Europäisches Patentamt

European Patent Office

Office européen des brevets

(19)

(11) Publication number: **0 289 062 B1**

# EUROPEAN PATENT SPECIFICATION

(12)

(45) Date of publication of patent specification: **26.08.92**  (51) Int. Cl.⁵: **G01R 27/22**, G01R 27/08

(21) Application number: **88200532.5**

(22) Date of filing: **23.03.88**

(54) **Method and device for measuring the conductivity of a liquid with check of the transfer resistance between an electrode and the liquid.**

(30) Priority: **24.03.87 NL 8700688**

(43) Date of publication of application:
**02.11.88 Bulletin 88/44**

(45) Publication of the grant of the patent:
**26.08.92 Bulletin 92/35**

(84) Designated Contracting States:
**AT BE CH DE ES FR GB GR IT LI LU NL SE**

(56) References cited:
**FR-A- 2 291 490**
**FR-A- 2 445 532**

(73) Proprietor: **Yokogawa Europe B.V.**
**Radiumweg 30**
**NL-3812 RA Amersfoort(NL)**

(72) Inventor: **Beijk, Jozeph Michael, Ir.**
**van Tuyllstraat 1A**
**NL-3829 AA Hooglanderveen(NL)**

(74) Representative: **de Wit, Gerard Frederik, Ir. et al**
**Octrooi- en Merkenbureau De Wit B.V. Breitnerlaan 146**
**NL-2596 HG Den Haag(NL)**

Rank Xerox (UK) Business Services

## Description

The invention relates to a method for measuring the conductivity of a liquid in which a current is fed through a liquid via first or current electrodes, which current is measured and the voltage of voltage electrodes is measured current-free, the voltage electrodes being positioned in the current field of the current electrodes and to a device for applying the method.

This method for measuring the conductivity of a liquid has the advantage that the measured value of this conductivity in a relatively high degree is independent on the transfer resistance between the electrode and the liquid. Further any influence of polarisation on the current electrodes is compensated in a high degree, also because no polarisation will occur at the voltage electrodes.

Examples of the state of the art are depicted in FR-A-2 445 532 and FR-A-2 291 490.

With these and other known systems, soiling of the electrodes with a soiling layer having a higher resistivity than the electrodes and/or the liquid leads to an increase of the voltage to be applied to the current electrodes to obtain the same current increases, it is true, but the quotient of the current between the current electrodes and the voltage between the voltage electrodes remains proportional with the specific conductivity of the liquid. A change of this proportion can only occur, when the current transfer between a current electrode and the liquid predominantly changes of place, for instance because the current electrode is covered over an important portion with a practically insulating layer and the current transfer from the electrode to the liquid on the average is shifted to another location than with unsoiled electrodes.

A serious drawback of such a device is, that with soiling of the electrode a considerable time no disturbances are established until the electrode is soiled in a degree that it can become insulated, which would put the measurement out of action, which fact can inflict great damages, for instance with continuous control of a process.

Therewith it is important that solely the voltage between the current electrodes is no measure for an increase, if any, of the transfer resistance between these electrodes and the liquid, because an increased total resistance can be attributed as well to an increase of the specific resistance of the liquid as to soiling of at least one of the electrodes.

The invention aims to provide, with simple means, the possibility to establish the increase of the transfer resistance between an electrode and the liquid.

Accordingly the invention provides a method as defined in claim 1 and a device as defined in claim 2.

Because the voltage electrodes by reason of the current-free measurement have no voltage drop over a transfer resistance, if any, between the liquid and the electrode, an increase of the voltage over a circuit containing a current electrode with respect to what should occur on base of the voltage difference between the voltage electrodes with unsoiled electrodes, is only dependent on the resistance between the current electrode and the liquid.

A simple embodiment of the invention provides that the further voltage is that between two current electrodes. Such a course of matters generally is satisfactory, but in case one wants to know, which of the current electrodes is soiled to which extend, it is also possible to measure the voltage between a current electrode and one of the voltage electrodes. To maintain the advantage that the voltage electrodes do not carry current the voltage measurement between a voltage electrode and a current electrode has also to be a current-free measurement.

In this connection it is pointed to it, that a current-free voltage measurement is known in the art and in practice can be obtained with a voltage measuring circuit with very high input impedance or a voltage measuring circuit based on compensation of occurring voltages. In the art of these days suchlike circuits often are realized by means of operational amplifiers.

The invention further encompasses a device for applying the method, which device is provided with a current source connected to current electrode terminals, a current meter being present for measuring the current flowing between the current electrodes and a voltage measuring circuit, which is connectable with voltage electrodes and is adapted for current-free measuring of the voltage between voltage electrodes and is characterized in that at least one further voltage measuring circuit is present connected between a current electrode terminal and a terminal of another current electrode or a terminal of a voltage electrode and that a comparator device is connected to both voltage measuring circuits and is adapted to determine the proportion of the measured voltages.

According to a further elaboration hereof measuring circuits may be provided for current-free measuring of voltages between the terminal of

(a) a first current electrode and a voltage electrode;

(b) a first voltage electrode and a second voltage electrode; and/or

(c) a voltage electrode and a further current electrode; and/or

(d) a measuring circuit for determining the voltage between current electrodes,

in which a device is present to determine the quotient of at least two of the said voltages and a comparator device to compare such a quotient with a fixed value and to issue a signal when a deviation of this quotient from said fixed value occurs.

An extremely simple embodiment of the inventive device is obtained with a voltage measuring circuit between the current electrodes, a voltage measuring circuit for current-free voltage measurement between the voltage electrodes and a device for ascertaining the proportion of these voltages, as well as a device for comparing this proportion with a predetermined value.

With application of the invention it is generally normal and sufficient, when there are two current electrodes and two voltage electrodes. In that case the invention can be applied for direct current and/or one phase alternating current. If one wants to measure for any reason with for instance three phase alternating voltage, then three current electrodes may be used. A further possibility is, that the liquid is not homogeneous and that in the current field of two or more current electrodes has to be measured at more than one location with different voltage electrodes, for instance by splitting up a voltage electrode or by application of more than one set.

Though the invention is directed to measure the conductivity, it is not necessary that the current flow through the liquid is only realized in view of said measurement. So the invention is also applicable in cases in which the current flow serves another purpose, such as electrolysis or suchlike, wherewith apart from the conductivity of the liquid also the transfer resistance between the liquid and a current carrying electrode is important.

The invention in the following is further elucidated by means of the drawing, in which

Figure 1 shows a first embodiment of the invention; and

Figure 2 a second embodiment.

In the drawing reference 1 indicates a current source, which via a current meter 2 is connected to a current electrode 3 contacting a schematically indicated liquid 4, the current circuit being closed via a further current electrode 5.

Between the current electrodes 3 and 5 voltage electrodes 6 and 7 are located, which via differential amplifiers 8 and 9 are connected to a voltage meter 10.

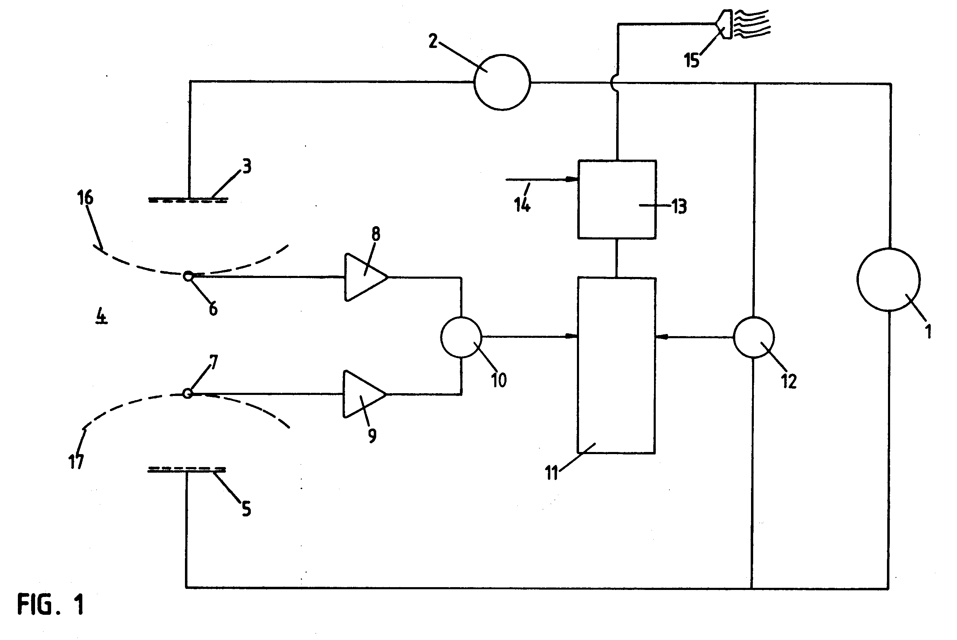

In the first embodiment shown in fig. 1 the voltage measured by means of voltage meter 10 is fed to a computing device, which also receives from voltage meter 12 the voltage existing between electrodes 3 and 5. The device 11 determines the quotient of these voltages and feeds it to a comparator device 13, which has a schematical input 14 to adjust a comparison value. The output of the comparator device 13 is connected to an alarm device 15.

In fig. 1 further equipotential surfaces 16 and 17 are schematically indicated, having the voltages of the electrodes 6 and 7 respectively. When with the electrodes 3 and 5 a layer with a large resistance occurs, schematically indicated with an interrupted line, which normally is very thin, the field distribution between the electrodes 3 and 5 will hardly change. This means that the transfer resistances of the electrodes 3 and 5 have no influence on the measuring results as long as these resistances are regularly covering these electrodes, of course until the measuring device stops its activity because one of the electrodes becomes insulated.

In case the electrodes 3 and 5 are one-sidedly covered, for instance due to flow of liquid 4 and for instance only the right edges remain free of an insulating coverage, the shape of the current field in the liquid 4 changes and consequently the location of the electrodes 6 and 7 with respect to this current field.

This leads to a fault in the deduction of the conductivity of the liquid 4 from the quotient of current between electrodes 3 and 5 and the voltage between electrodes 6 and 7 respectively.

If, however, soil of the electrodes 3 and 5 occurs in such a degree, in which a resistance occurs which is comparable with the resistance of the liquid mass between these electrodes, then the voltage indicated by voltage meter 12 will increase without increase of the voltage indicated by voltage meter 10. This forms an indication, that on one or both of the electrodes a resistance has been formed. In the comparator device 13 the measured quotient of the voltages between the electrodes 6 and 7 and the electrodes 3 and 5 is compared with a fixed value, which either can be determined experimentally with clean electrodes or is a characterizing quantity for the used installation. Signalling a too big deviation can form an indication to clean or replace the electrodes 3 and 5.

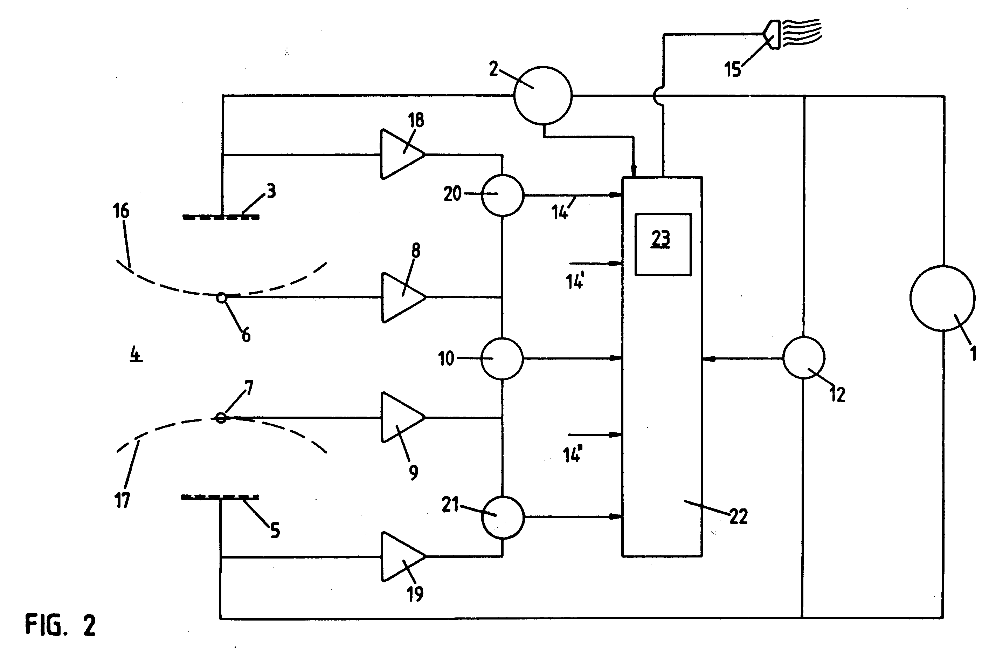

In fig. 2 a scheme has been indicated of application of the invention with which it is possible to check of each of the electrodes 3 and 5 if they have an increased transfer resistance with respect to the liquid 4. This is attained by measuring the voltage between each of them and one of the voltage electrodes 6 and 7. This measurement again happens preferably current-free, for instance by means of differential amplifiers 18 and 19 and voltage meters 20 and 21 which feed their output voltage to a processor 22. The voltage over the electrodes 6 and 7 is also fed to the processor 22 via the voltage meter 10. This processor has a memory 23, in which the quotients of these voltages with unsoiled electrodes are memorized and the alarm device 15 is again put in action, if a deviation between the measured and the predetermined values of these quotients is ascertained.

The processor 22 receives also the voltage 12 to check in that way whether the sum of the voltages of the voltage meters 20, 10 and 21 equals that of the voltage meter 12 or not. If this is not the case this fact has to signalled too.

Of course fig. 2 is only a scheme and it is for instance possible to let the voltage meters 20,10 and 21 exist in a single one, which alternately is switched on the outputs of the differential amplifiers 18,8; 8,9 and 9,19. The processor 22 can again receive adjustment quantities 14' and 14", which indicate the proportions of the voltages indicated by the voltage meters 20,21 and 10 with unsoiled electrodes.

Of course the processor 22 can cooperate with display means to determine and indicate the specific conductivity or the specific resistance of the liquid 4 from the current measured by meter 2 and the voltage occurring between the voltage electrodes 6 and 7. Also the resistances, due to soiling of each of the electrodes 3 and 5 can be indicated.

If no transfer resistance occures between the electrodes 3 or 5 and the liquid 4 the voltage between electrodes 3 and 6 is proportional to the resistance of the liquid body between electrodes 3 and equipotential surface 16, that between electrodes 6 and 7 to the resistance of the liquid body between the equipotential surfaces 16 and 17 and that between 7 and 5 to the resistance of the liquid body between the equipotential surface 17 and the electrode 5.

These liquid bodies keep their shape and dimensions, so that deviations in the proportion between the measured voltages are to be attributed to the occurrence of additional resistances. Normally these are due to soiling, but a change, if any, by impedances caused by polarisation is also detected.

In the shown embodiment it is assumed that source 1 is a voltage source, so that meter 2 serves the purpose of current measurement. However, in case 1 is a current source, causing a predetermined current to flow between electrodes 3 and 5, this predetermined current is the "measured" current value and current meter 2 is superfluous.

## Claims

1. Method for measuring the conductivity of a liquid, in which a current is fed through a liquid via first or current electrodes (3,5), which current is measured and the voltage of voltage electrodes (6,7) is measured current-free, the voltage electrodes being positioned in the current field (16,17) of the current electrodes (3,5), characterized in that as a further voltage that between one of the current electrodes (3,5) and one of the voltage electrodes (6,7) or the other of the current electrodes (5,3) is measured and from the proportion of the measured voltages is ascertained, whether the transfer resistance of at least one of the current electrodes (3,5) has an augmented value.

2. Device for applying the method of claim 1, provided with a current source (1) connected to current electrodes (3,5), a current meter (2) being present for measuring the current flowing between the current electrodes (3,5) and a voltage measuring meter (10), which is connected with voltage electrodes (6,7) and is adapted for current-free measuring of the voltage between voltage electrodes (6,7), characterized in that at least one further voltage measuring meter (12,20,21) is present connected between one of the current electrodes (3,5) and the other of the current electrodes (5,3) or one of the voltage electrodes (6,7) and that a comparator device is connected to both voltage measuring meters (10 and (12 or 20 or 21)) and is adapted to determine the proportion of the measured voltages.

3. Device according to claim 2, characterized by measuring meters (20,10,21) for current-free measuring between the terminal of

   (a) a first current electrode (3) and a voltage electrode (6);

   (b) a first voltage electrode (6) and a second voltage electrode (7);

   (c) a voltage electrode (7) and a further current electrode (5);

   (d) a measuring meter (12) for determining the voltage between current electrodes (3,5),

in which a device is present to determine the quotient of at least two of the said voltages and a comparator device to compare such a quotient with a fixed value and to issue a signal when a predetermined deviation of this quotient from said fixed value occurs.

4. Device according to claim 2, characterized by a voltage measuring meter (12) between the current electrodes (3,5), a voltage measuring meter (10) for current-free voltage measurement between the voltage electrodes (6,7) and a device (11,22) for ascertaining the proportion of these voltages, as well as a device (13,22) for comparing this proportion with a predetermined value.

**Patentansprüche**

1. Verfahren für das Messen des Leitvermögens einer Flüssigkeit, in welchem ein Strom durch eine Flüssigkeit geführt wird mittels erster oder Stromelektroden (3,5), welcher Strom gemessen wird und die Spannung der Spannungselektroden (6,7) stromfrei gemessen wird, wobei die Spannungselektroden im Stromfeld (16,17) der Stromelektroden (3,5) angeordnet sind, dadurch gekennzeichnet, dass als eine weitere Spannung diejenige zwischen einer der Stromelektroden (3,5) und einer der Spannungselektroden (6,7) oder der anderen der Stromelektroden (5,3) gemessen wird und dass aus dem Verhältnis der gemessenen Spannungen festgestellt wird, ob der Uebertragungswiederstand wenigstens einer der Stromelektroden (3,5) einen erhöhten Wert hat.

2. Vorrichtung zur Anwendung des Verfahrens nach Anspruch 1, versehen mit einer Stromquelle (1) die mit Stromelektroden (3,5) verbunden ist, wobei ein Strommesser (2) anwesend ist zur Messung des Stromes der zwischen den Stromelektroden (3,5) fliesst und ein Spannungsmesser (10) der mit Spannungselektroden (6,7) verbunden ist und eingerichtet ist für stromfreie Messung der Spannung zwischen den Spannungselektroden (6,7), dadurch gekennzeichnet, dass wenigstens ein weiterer Spannungsmesser (12,20,21) anwesend ist, der zwischen einer der Spannungselektroden (3,5) und der anderen der Stromelektroden (5,3) oder einer der Spannungselektroden (6,7) verbunden ist und dass eine Vergleichungsvorrichtung mit den beiden Spannungsmessern (10 und (12 oder 20 oder 21)) verbunden ist und eingerichtet ist das Verhältniss der gemessenen Spannungen zu ermitteln.

3. Vorrichtung nach Anspruch 2, gekennzeichnet durch Messer (20,10,21) für stromfreie Messung zwischen der Klemme

    (a) einer ersten Stromelektrode (3) und einer Spannungselektrode (6);
    (b) einer ersten Spannungselektrode (6) und einer zweiten Spannungselektrode (7);
    (c) einer Spannungselektrode (7) und einer weiteren Stromelektrode (5);
    (d) eines Spannungsmessers (12) zur Ermittlung der Spannung zwischen den Stromelektroden (3,5),

in welcher eine Vorrichtung zur Ermittlung des Quotienten wenigstens zweier der genannten Spannungen und eine Vergleichungsvorrichtung zur Vergleichung eines derartigen Quotienten mit einem festen Wert und zur Abgabe eines Signals wenn eine vorher bestimmte Abweichung dieses Quotienten vom genannten festen Wert eintritt, anwesend sind.

4. Vorrichtung nach Anspruch 2 gekennzeichnet durch einen Spannungsmesser (12) zwischen den Stromelektroden (3,5), eine Spannungsmesser (10) zur stromfreien Messung der Spannung zwischen den Spannungselektroden (6,7) und eine Vorrichtung (11,22) zur Ermittlung des Verhältnisses dieser Spannungen, sowie eine Vorrichtung (13,22) zur Vergleichung dieses Verhältnisses mit einem festen Wert.

**Revendications**

1. Procédé de mesure de la conductivité d'un liquide dans lequel un courant est appliqué à travers un liquide au moyen de premières électrodes ou électrodes de courant (3,5), lequel courant est mesuré et la tension des électrodes de tension (6,7) est mesurée en l'absence de courant, les électrodes de tension étant placées dans le champ de courant (16,17) des électrodes de courant (3,5), caractérisé en ce qu'une tension autre que la tension entre les électrodes de courant (3,5) et la tension entre l'une des électrodes de tension (6,7) ou entre l'autre des électrodes de courant (5,3) est mesurée et dans lequel à partir de la proportion des tensions mesurées, on vérifie si la résistance de transfert d'au moins une des électrodes de courant (3,5) a une valeur augmentée.

2. Appareil pour la mise en oeuvre du procédé selon la revendication 1, comportant une source de courant (1) reliée aux électrodes de courant (3,5), un ampèremètre (2) étant installé pour mesurer le courant qui circule entre les électrodes de courant (3,5) et un voltmètre (10) qui est connecté aux électrodes de tension (6,7) et conçu pour mesurer la tension en l'absence de courant entre les électrodes de tension (6,7), caractérisé en ce qu'au moins un autre voltmètre (12,20,21) est connecté entre l'une des électrodes de courant (3,5) et l'autre des électrodes de courant (5,3) ou entre une des électrodes de tension (6,7) et en ce qu'un dispositif comparateur est connecté aux deux voltmètres (10 et 12 ou 20 ou 21) et conçu pour déterminer la proportion des tensions mesurées.

3. Appareil selon la revendication 2, caractérisé en ce qu'il comprend des voltmètres (20,10,21) pour mesurer la tension en l'absence de courant entre les bornes suivantes:

    (a) une première électrode de courant (3) et une électrode de tension (6);

(b) une première électrode de tension (6) et une seconde électrode de tension (7);

(c) une électrode de tension (7) et une autre électrode de courant (5);

(d) un voltmètre (12) pour déterminer la tension entre les électrodes de courant (3,5), dans lequel se trouve un dispositif pour déterminer le quotient d'au moins deux desdites tensions et un comparateur pour comparer ce quotient à une valeur fixe et émettre un signal lorsqu'un écart prédéterminé de ce quotient par rapport à ladite valeur fixe apparaît.

4. Appareil selon la revendication 2, caractérisé en ce qu'il comprend un voltmètre (12) monté entre les électrodes de courant (3,5), un voltmètre (10) pour mesurer la tension en l'absence de courant entre les électrodes de tension (6,7) et un dispositif (11,22) pour vérifier la proportion de ces tensions, ainsi qu'un dispositif (13,22) pour comparer cette proportion à une valeur prédéterminée.

FIG. 1

FIG. 2